# EUROPÄISCHE PATENTSCHRIFT

(11) **EP 1 398 877 B1**
(45) Veröffentlichungstag und Bekanntmachung des Hinweises auf die Patenterteilung: **05.04.2006**
(21) Anmeldenummer: 03018528.4
(22) Anmeldetag: 16.08.2003
(51) Int. Cl.: H03K 17/0812, H03K 17/687, H03K 17/785

(54) **Verfahren zur Fehlererkennung in der Datenübertragung zu einer Treiberschaltung**
Method for the detection of faults of a data transmission to a driver circuit
Procédé pour détecter des erreurs dans une transmission d'informations à un circuit d'attaque

(30) Priorität: 07.09.2002 DE 10241564
(43) Veröffentlichungstag der Anmeldung: 17.03.2004
(60) Teilanmeldung: 05027272.3
(73) Patentinhaber: SEMIKRON Elektronik GmbH & Co. KG, 90431 Nürnberg (DE)
(72) Erfinder: Masannek, Jürgen, 90461 Nürnberg (DE)

(56) Entgegenhaltungen:
- EP-A- 0 265 315
- DE-A- 19 518 860
- US-A- 5 126 588

## Beschreibung

Die Erfindung beschreibt ein Verfahren zur Fehlererkennung in der Datenübertragung der Ansteuersignale eines Kontrollrechners zu einer Treiberschaltung für Leistungshalbleiterschalter, wobei diese Leistungshalbleiterschalter in einer Halbbrückenschaltung oder einer daraus aufgebauten Schaltung, wie beispielhaft einer 3-Phasen Vollbrücke in einem Wechselrichter, angeordnet sind.

Derartige Leistungshalbleiterschalter sind nach dem Stand der Technik IGBTs (insulated gate bipolar transistor) oder MOS-FETs (Metalloxid-Feldeffekttransistor) und vorteilhafterweise in Leistungshalbleitermodulen, wie sie beispielhaft aus der DE 195 22 173 A1 bekannt sind, angeordnet. Derartige Leistungshalbleitermodule werden ebenfalls nach dem Stand der Technik, wie er beispielhaft aus U. Nicolai et al., "Applikationshandbuch IGBT- und MOSFET- Leistungsmodule", ISBN 3-932633-24-5, Seite 176 bis 196 bekannt ist, durch eine sog. Treiberschaltung angesteuert. Diese Treiberschaltung erhält von einem Kontrollrechner hierzu die Steuersignale, mit jeweils einer Leitung pro Leistungshalbleiterschalter. Die Treiberschaltung wandelt die Steuersignale auf den zur Ansteuerung der Leistungshalbleiterschalter benötigten Pegel.

Vorzugsweise bei Leistungshalbleitermodulen sowie deren Treibern, bzw. in Anwendungen dieser, wie beispielsweise der Betrieb von Drehstromgeneratoren oder -motoren, mit höheren Leistungen, größer 100kW, sind der Kontrollrechner von dem Leistungshalbleitermodul mit dem direkt benachbarten Treiber einen bis mehrerer zehn Meter voneinander getrennt angeordnet, um Störungen des Kontrollrechners durch das Leistungshalbleitermodul bzw. die Anwendung zu vermeiden. Bei Leitungslängen von mehreren Metern können verschiedenartige Störungen in dem übertragenen Ansteuersignal auftreten.

Aus der DE 195 18 860 A1 ist eine Schaltungsanordnung zur Ansteuerung zweier Schalter in Halbbrückenanordnung bekannt, wobei ein pulsweitenmoduliertes Eingangssignal den jeweiligen Treiber eines TOP- und eines BOT- Schalters ansteuert. Die jeweiligen Treiber erzeugen hieraus ein Signal für die jeweiligen Schalter. Dieses Signal wird auch dem jeweils anderen Schalter zugeführt, der es logisch mit dem Eingangssignal verknüpft und somit wird eine Verriegelung der beiden Schalter gegeneinander realisiert.

Die vorliegende Erfindung hat die Aufgabe, ein Verfahren zur Erkennung von Störungen in der Datenübertragung der Ansteuersignale eines Kontrollrechners zu einer Treiberschaltung für Leistungshalbleiterschalter vorzustellen.

Die Aufgabe wird gelöst durch die Maßnahmen des Anspruchs 1. Eine vorteilhafte Ausgestaltung ist im abhängigen Anspruch genannt.

Der Grundgedanke der Erfindung liegt darin, bei jedem Einschalten jedes Leistungshalbleiterschalter in der Treiberschaltung einen Zähler hoch zu zählen und bei Einschalten des komplementären Leistungshalbleiterschalter diesen Zähler herunter zu zählen.

Diese Maßnahme basiert auf jeweils einem Zähler pro Leistungshalbleiterschalter. Wird dieser Leistungshalbleiterschalter eingeschalten, so wird der zugehörige Zähler um eins hochgezählt, wird der komplementäre Leistungshalbleiterschalter eingeschalten, so wird der Zähler um eins heruntergezählt. Da beide Schalter nur alternierend eingeschalten werden dürfen, darf der Wertebereich des Zählers nur Null oder Eins sein. Jeglicher andere Wert repräsentiert einen Fehler.

Spezielle Ausgestaltungen der erfinderischen Lösungen werden an Hand der Fig. 1 bis 4 erläutert.
- Fig. 1: zeigt die Ansteuersignale sowie die daraus erzeugten Enable-Signale im fehlerfreien Betrieb.
- Fig. 2: zeigt die Ansteuersignale sowie die daraus erzeugten Enable-Signale im fehlerbehafteten Betrieb.
- Fig. 3: zeigt die Ansteuersignale sowie die jeweiligen Zähler im fehlerfreien Betrieb.
- Fig. 4: zeigt die Ansteuersignale sowie die jeweiligen Zähler im fehlerbehafteten Betrieb.

Alle nachfolgende Figuren beziehen sich auf den folgenden beispielhaften Anwendungsfall. Der Kontrollrechner befindet sich mehrere zehn Meter entfernt von dem Leistungshalbleitermodul mit dazugehöriger Treiberschaltung. Das Leistungshalbleitermodul besteht aus 3 Halbbrücken, jede Halbbrücke besteht ihrerseits aus jeweils einem ersten Schalter (TOP-Schalter) und einem zweiten Schalter (BOT-Schalter), und steuert einen Drehstromgenerator an. Zur Vereinfachung wird im folgenden das erfinderische Verfahren nur anhand einer Halbbrücke beschreiben, die Verallgemeinerung auf alle 3 Halbbrücken ist offensichtlich. Der Kontrollrechner und die Treiberschaltung sind mittels Lichtwellenleiter miteinander verbunden.

Soll ein Leistungshalbleiterschalter eingeschaltet sein sendet der Kontrollrechner für diesen Zeitabschnitt ein Signal auf der entsprechenden Signalleitung. Aus technischen Gründen, beispielhaft der Vermeidung von Kurzschlüssen in der Halbbrücke, ist eine Totzeit erforderlich, ein Zeitraum in dem keiner der beiden Leistungshalbleiterschalter der Halbbrücke eingeschaltet sein darf. Diese Totzeit ist abzuwarten, bevor nach dem Ausschalten eines Leistungshalbleiterschalters der jeweils komplementäre eingeschaltet werden darf. Weiterhin dürfen im Regelfall beide Leistungshalbleiterschalter nur alternierend angeschalten werden. Aufgrund von Störungen, beispielhaft durch mangelhafte Befestigung der Lichtwellenleiter am Empfänger der Treiberschaltung, treten in der Treiberschaltung verschiedenartige Störungen in den übertragenen Ansteuersignalen auf.

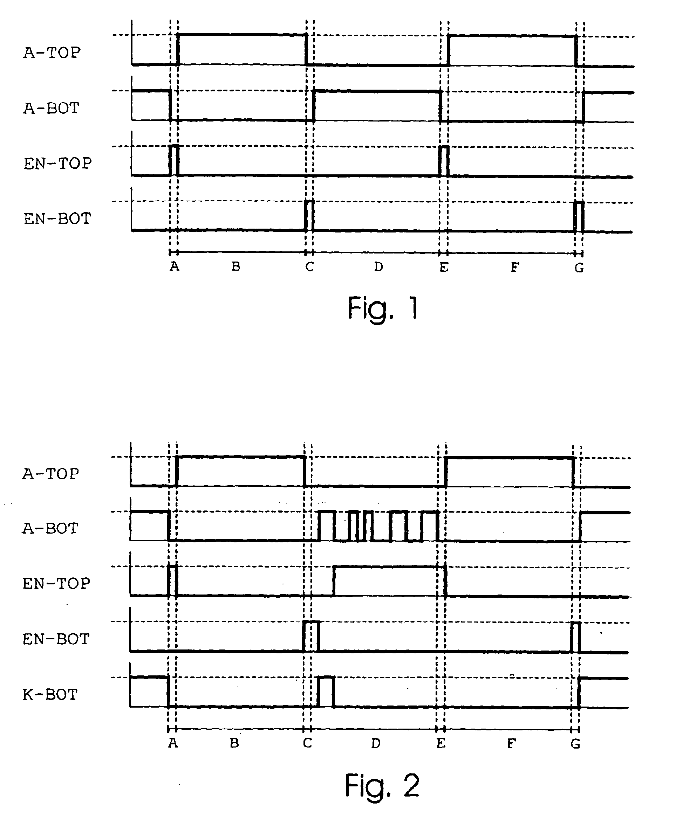

Fig. 1 zeigt die Ansteuersignale nach dem Stand der Technik sowie die daraus erzeugten Enable-Signale im fehlerfreien Betrieb. Die erste Kurve (A-TOP) zeigt das vom Kontrollrechner zur Treiberschaltung übertragenen Ansteuersignal. Hierbei entspricht ein Pegel von "high", dass die Treiberschaltung den TOP-Schalter einschalten soll. Dies geschieht nach dem Stand der Technik indem der Pegel am Ausgang des Empfängers des Lichtwellenleiters durch die Treiberschaltung auf das Potential des Leistungshalbteiterschalters umgesetzt und verstärkt und dieses Signal an den Steuereingang des Leistungshalbleiterschalters angelegt wird. Ein Pegel von "low" entspricht einen auszuschaltenden Leistungshalbleiterschalter.

Am Ende des Zeitraums (A) soll der TOP-Schalter eingeschaltet werden. Die Einschaltdauer ist der Zeitraum (B). Die abfallende Flanke des Ansteuersignals (A-TOP) des TOP-Schalters setzt das Enable-Signale (EN-BOT) des BOT-Schalters. Nach der Totzeit (C), während der kein Leistungshalbleiterschalter eingeschaltet sein darf, wird vom Kontrollrechner das Ansteuersignal (A-BOT) für den BOT-Schalter angelegt. Der BOT-Schalter wird, da sowohl das Ansteuersignal (A-BOT) als auch das Enable-Signal (EN-BOT) an- bzw. vorliegt zu Beginn des Zeitraumes (D) angeschalten. Durch das Anschalten des BOT-Schalters wird dessen Enable-Signal (EN-BOT) wieder zurückgesetzt.

Analog verläuft das Anschalten des TOP-Schalters zu Beginn des Zeitraumes (F), da hier das durch das Ausschalten des BOT-Schalters erzeugte Enable-Signal (EN-TOP) als auch das Ansteuersignal (A-TOP) des Kontrollrechners vor- bzw. anliegt. Auch hier wird das Enable-Signale (EN-TOP) durch das Anschalten des TOP-Schalters zurückgesetzt.

Fig. 2 zeigt die Ansteuersignale sowie die daraus erzeugten Enable-Signale im fehlerbehafteten Betrieb. Als Fehler wird hier ein nicht konstant anliegendes Ansteuersignal (A-BOT) im Zeitraum (D) angenommen. Das hier dargestellte Ansteuersignal im Zeitraum (D) würde auf Grund der hohen Frequenz den BOT-Schalter durch hochfrequente Schaltvorgänge zerstören. Zu Beginn des Zeitraumes (D) liegt sowohl das Enable-Signal (EN-BOT), das durch das vorhergehende Abschalten des TOP-Schalters erzeugt wurde, vor als auch das Ansteuersignal (A-BOT) des Kontrollrechners an. Die Treiberschaltung schaltet somit den BOT-Schalter ein wie dies die korrigierte Kurve (K-BOT) darstellt, gleichzeitig wird das Enable-Signal (EN-BOT) zurückgesetzt.. Nachdem der BOT-Schalter innerhalb des Zeitraumes (D) nach kurzer Zeit aufgrund eines fehlenden Ansteuersignals wieder ausgeschaltet wird, wird dieser bei erneut vorhandenem Ansteuersignal nicht wieder eingeschalten, da das entsprechende Enable-Signal (EN-BOT) aufgrund eines fehlenden Ausschaltens des TOP-Schalters nicht vorliegt.

Somit wird ein hochfrequentes Ein- und Ausschalten und damit die wahrscheinliche Zerstörung desjenigen Schalters, dessen Ansteuersignal störungsbehaftet ist wirksam vermieden.

Um dem Kontrollrechner über eine entsprechende Signalleitung einen Fehler mitteilen zu können, werden die beiden Signale (A-TOP) und (K-TOP) bzw. (A-BOT) und (K-BOT) verglichen. Eine unterschiedliche Signallänge signalisiert einen Fehler.

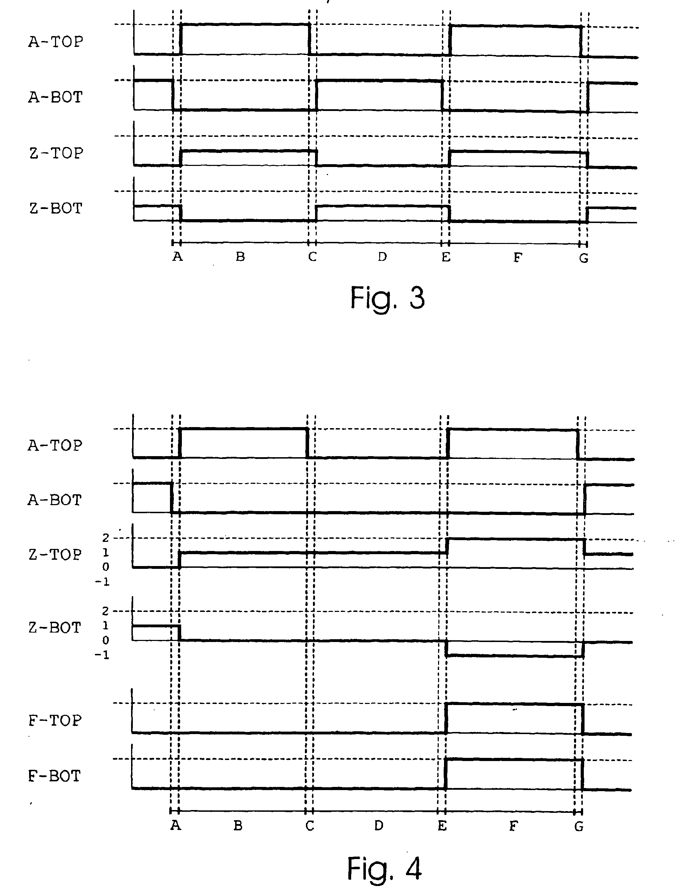

Fig. 3 zeigt die Ansteuersignale nach dem Stand der Technik sowie die jeweiligen erfindungsgemäßen Zähler im fehlerfreien Betrieb. Hierbei sind die Ansteuersignal wie bereits unter Fig. 1 beschrieben. Der Zähler des TOP-Schalters (Z-TOP) wird zu Beginn des Zeitraumes (B) hochgezählt, da auch das Ansteuersignal (A-TOP) anliegt. Dieser Zähler (Z-TOP) wird wieder heruntergezählt, sobald ein Ansteuersignal (A-BOT) für den BOT-Schalter anliegt. Ein analoges Verhalten weist der Zähler (Z-BOT) für den BOT-Schalter auf. Der Wertebereich jedes Zählers enthält als erlaubte Werte somit ausschließlich Null oder Eins.

Fig. 4 zeigt die Ansteuersignale sowie die jeweiligen Zähler im fehlerbehafteten Betrieb. Als Fehler wird hier ein vollständig fehlendes Ansteuersignal (A-BOT) für den BOT-Schalter im Zeitraum (D) angenommen. Auf Grund des Ausbleibens des Ansteuersignals und des Eintreffens eines weiteren Ansteuersignal (A-TOP) zu Beginn des Zeitraums (F) wird der Zähler (Z-TOP) weiter heraufgezählt und nimmt somit den nicht erlaubten Wert "2" an. was einen Fehlerfall (F-TOP) signalisiert und über eine entsprechende Signalleitung an den Kontrollrechner übertragen werden kann. Ein Zähler (Z-BOT) würde bei analoger Funktionsweise zum gleichen Zeitpunkt einen Fehler erkennen, da er den nicht erlaubten Wert.

## Patentansprüche

1. Verfahren zur Fehlererkennung in der Datenübertragung zu einer Treiberschaltung für Leistungshalbleiterschalter,
angeordnet in einer Halbbrückenschaltung oder einer daraus aufgebauten Schaltung, wobei für jeden Leistungshalbleiterschalter (TOP, BOT) ein Ansteuersignal (A-TOP, A-BOT) von einem Kontrollrechner zur Treiberschaltung übertragen wird
und
für jeden Leistungshalbleiter schalter ein jeweiliger Zähler (Z-TOP. Z-BOT) um eins hochgezahlt wird sobald dessen Ansteuersignal beginnt anzuliegen und dieser Zähler um eins heruntergezählt wird, sobald das jeweils andere Ansteuersignal beginnt anzuliegen und ein Fehlersignal (F-TOP, F-BOT) erzeugt wird, sobald der Wert eines Zählers außerhalb des erlaubten Wertebereichs, der 0 und 1 umfasst, liegt.

2. Verfahren nach Anspruch 1, wobei
die Datenübertragung mittels Lichtsignalen in Lichtwellenleitern erfolgt.

## Claims

1. Method for error detection in the transmission of data to a driving circuit for semiconductor power cut-out switches,
arranged in a half-bridge circuit or a circuit constructed from it, wherein an activating signal (A-TOP, A-BOT) is transmitted from a control computer to the driving circuit for each semiconductor power cut-out switch (TOP, BOT), and
wherein a corresponding counter (Z-TOP, Z-BOT) is incremented by one for each semiconductor power cut-out switch as soon as its activating signal commences contact, and this counter is decremented by one as soon as the other corresponding activating signal commences contact, and wherein an error signal (F-TOP/ F-BOT) is generated as soon as the value of the counter lies outside the permitted value range, which includes 0 and 1.

2. Method according to Claim 1, wherein the data transmission takes place by means of light signals in light wave conductors.

## Revendications

1. Procédé de détection d'erreur dans la transmission de données à un circuit d'attaque pour des interrupteurs à semi-conducteurs de puissance placés dans un circuit à demi-pont ou dans un circuit basé sur celui-ci,
un signal de commande (A-TOP, A-BOT) étant transmis d'un ordinateur de contrôle au circuit d'attaque pour chaque interrupteur à semi-conducteur de puissance (TOP, BOT),
et, pour chaque interrupteur à semi-conducteur de puissance, un compteur respectif (Z-TOP, Z-BOT) étant incrémenté de un dès que son signal de commande commence à être appliqué et ce compteur étant décrémenté de un dès que l'autre signal de commande respectif commence à être appliqué et un signal d'erreur (F-TOP, F-BOT) étant produit dès que la valeur d'un compteur se trouve en dehors de la plage de valeur autorisée qui comprend 0 et 1.

2. Procédé selon la revendication 1, la transmission de données s'effectuant au moyen de signaux lumineux dans des guides d'ondes lumineuses.
